# EUROPÄISCHE PATENTSCHRIFT

(11) **EP 2 585 622 B1**
(45) Veröffentlichungstag und Bekanntmachung des Hinweises auf die Patenterteilung: **17.01.2018**
(21) Anmeldenummer: 11727116.3
(22) Anmeldetag: 03.06.2011
(51) Int. Cl.: C23C 14/02, C23C 14/32, C23C 14/35, C23C 14/58, C23C 14/00

(54) **ARC-VERDAMPFUNGSQUELLE MIT DEFINIERTEM ELEKTRISCHEM FELD**
ARC DEPOSITION SOURCE HAVING A DEFINED ELECTRIC FIELD
SOURCE D'ÉVAPORATION PAR ARC PRÉSENTANT UN CHAMP ÉLECTRIQUE DÉFINI

(30) Priorität: 22.06.2010 US 357272 P
(43) Veröffentlichungstag der Anmeldung: 01.05.2013
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); HAGMANN, Juerg, CH-9468 Sax (CH)
(74) Vertreter: Kempkens, Anke
(86) Internationale Anmeldenummer: PCT/EP2011/002734
(87) Internationale Veröffentlichungsnummer: WO 2011/160766

(56) Entgegenhaltungen:
- EP-A1- 1 970 464
- US-A- 3 625 848
- US-A- 4 551 221
- US-A- 5 306 407
- US-A- 5 380 421

## Beschreibung

Die Erfindung betrifft eine ARC-Verdampferquelle nach dem Oberbegriff des Anspruchs 1. Als ARC-Verdampferquelle wird in der vorliegenden Beschreibung eine Vorrichtung bezeichnet, mit deren Hilfe ein Lichtbogen, welche ihren Brennfleck auf einer Kathode hat, im Vakuum gezündet werden kann, wobei durch die Kathode (=Target) das zu verdampfende Material bereitgestellt wird und der Brennfleck die Verdampfung des Targetmaterials zu Folge hat.

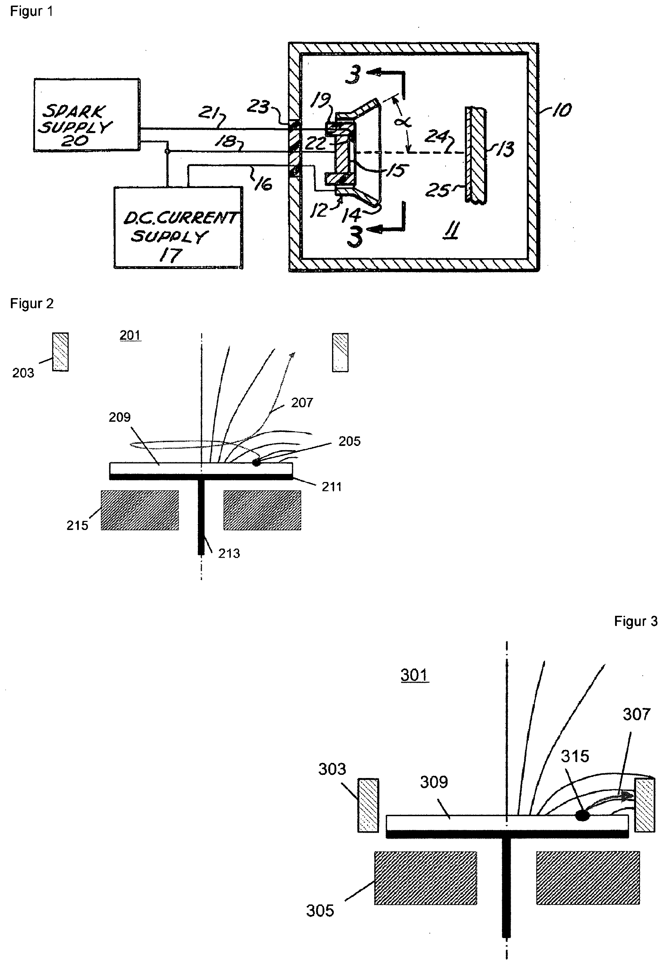

ARC-Verdampfungsquellen sind aus dem Stand der Technik bekannt. So offenbart Snaper in US 3625848 eine "Strahtenkanone" (beam gun) mit einer Kathode und einer Anode die so angeordnet sind, dass eine Funkenentladung zwischen ihnen zustande kommt. Die Kathode wird dabei aus dem Material hergestellt, welches abgeschieden werden soll. Die dort beschriebene Anode hat eine konisch zulaufende Geometrie und ist in unmittelbarer Nachbarschaft zur zylindrischen Kathode angeordnet. Die Anordnung gemäss diesem Stand der Technik ist in Figur 1 gezeigt. Magnetische Mittel kommen in dieser Anordnung nicht zur Anwendung. Die Bewegung des Brennflecks auf dem Target dürfte daher für heutige Verhältnisse eine sehr langsame sein, obwohl diese damals als schnell beschrieben wurde. Eine langsame Bewegung des Brennfleckes führt u.a. zu einer erhöhten Rauhigkeit der mittels der ARC-Verdampfungsquelle hergestellten Schichten.

Demgegenüber wird inder Patentschrift US 4 620 913 von Clark Bergman ein Multi ARC Vacuum System offenbart bei dem magnetische Mittel zum Einsatz kommen Dabei handelt es sich um eine ARC Quelle mit Anodenbeschaltung, wobei die Kammer oder eine elektrisch isoliert eingeführte Anode verwendet wird. Dabei ergibt sich aber der Nachteil, dass L lediglich ein Teil der Magnetfelder, welche vom Target ausgehen, in die Anode führt. Vorteil der dortigen Apparatur ist eine stabile Funkenführung speziell bei kleinen Entladeströmen. Eine Stromaufteilung zwischen Kammer und eingeführter Anode wird durch eine zusätzliche Beaufschlagung der eingeführten Anode mit einer positiven Spannung erreicht.

Larrinaga offenbart in EP1970464A1 eine ARC-Verdampfungsquelle, wobei ein Magnetsystem zur Führung des Brennflecks verwendet wird.

Axenov offenbart in US4551221 eine ARC-Verdampfungsquelle, wobei die Magnetfeldlinien die Anode nicht treffen, sondern so generiert werden, dass sie parallel zu der Anodenoberfläche laufe, so dass das Plasma, das aus dem verdampften Material produziert wird, durch die Rohranode entlang transportiert wird.

Hauzer offenbart in US5306407 ein Verfahren sowie eine Vorrichtung zum Beschichten von Substraten, wobei sowohl eine Bogenentladungsverdampfung als auch eine Kathodenzerstäubung vorgenommen, und die Bogenentladungsverdampfung vor der Kathodenzerstäubung durchgeführt wird.

Gorokhovsky offenbart in US5380421 eine Vorrichtung zur Herstellung von Beschichtungen im Vakuum, welche mit einer rechteckigen Kathodenplatte und Primär- und Hilfsanoden, so wie mit statischen und dynamischen magnetischen Stabilisierungssubsystemen vorgesehen ist. Die statischen und dynamischen magnetischen Stabilisierungssysteme betreiben den Lichtbogen auf der Arbeitsfläche der Kathode, um den Lichtbogen zu stabilisieren.

Es besteht jedoch weiter ein Bedürfnis nach einer ARC-Verdampferquelle welche es erlaubt, bei konstant hoher Verdampfungsrate Schichten mit geringer Oberflächenrauigkeit herzustellen. Es ist die Aufgabe der vorliegenden Erfindung eine solche ARC-Verdampferquelle anzugeben.

Erfindungsgemäss wird die Aufgabe durch die ARC-Verdampferquelle gemäss Anspruch 1 gelöst. In den abhängigen Ansprüchen sind unterschiedliche und vorteilhafte Ausführungsformen der erfindungsgemässen ARC-Verdampfungsquelle.

Die erfindungsgemässe ARC-Verdampfungsquelle umfasst eine Kathode (Target), eine Anode und magnetische Mittel, die es erlauben, die magnetischen Feldlinien auf kurzer Verbindung von der Targetoberfläche zur Anode zu führen.

Die Anode ist in der unmittelbaren Nachbarschaft der Kathode angeordnet, so dass die Verbindung der Kathode mit der Anode über Magnetfeldlinien von jedem Punkt der zu verdampfenden Oberfläche des Targets, welcher einer Erosion ausgesetzt ist, gewährleistet ist.

Dabei sind die magnetischen Mittel so ausgestaltet, dass die Komponente parallel zur Targetoberfläche deutlich grösser ist als die Komponente senkrecht zur Targetoberfläche. Es können magnetische Feldstärken von bis zu 500 Gauss in Verwendung kommen, d.h. deutlich höhere Feldstärken als die sonst in der PVD-Technologie zu Anwendung kommenden Magnetfeldstärken.

Die so beschriebene ARC-Quelle weißt im Vergleich mit dem Stand der Technik, höhere Beschichtungsraten bei gleichzeitig sehr glatten Schichten auf.

Die erfinderische ARC-Quelle ist selbst im Vakuum betriebsfähig, wobei eine hohe Funkengeschwindigkeit erreicht wird. Die ARC-Quelle wird dabei im Metallmode betrieben. Die so erzeugten Metalionen, wie z.B. Cr+, Ti+ können störungsfrei an das Substrat gelangen und zum Zweck des Metal Ionen Ätzens verwendet werden. Ein Betrieb bei geringem Entladestrom ist möglich.

Mittels sogenanntem "Prebiasing" lässt sich mit der erfindungsgemässen Anode die Ionenenergie zuverlässig einstellen.

Die Erfindung wird nun beispielhaft und mit Hilfe der Figuren im Detail dargestellt.
Figur 1 zeigt eine ARC-Verdampfungsquelle gemäss dem Stand der Technik
Figur 2 zeigt eine ARC-Verdampfungsquelle gemäss dem Stand der Technik
Figur 3 zeigt eine erste Ausführungsform einer erfindungsgemässen ARC-Verdampfungsquelle
Figur 4 zeigt eine Vakuumvorrichtung mit einer erfindungsgemässen ARC-Verdampfungsquelle
Figur 5 zeigt eine Vakuumvorrichtung mit einer ARC-Verdampfungsquelle gemäss Stand der Technik.
Figur 6 zeigt die Potentialverhältnisse bei einer Vorrichtung gemäss Figur 5
Figur 7 zeigt die Potentialverhältnisse bei einer erfindungsgemässen Vorrichtung gemäss Figur 4
Figur 8 zeigt eine weitere Ausführungsform einer erfindungsgemässen Vakuumvorrichtung
Figur 9 zeigt die Potentialverhältnisse bei einer erfindungsgemässen Vorrichtung gemäss Figur 4
Figur 10 zeigt eine weitere Ausführungsform einer erfindungsgemässen Vakuumvorrichtung
Figur 11 zeigt die Potentialverhältnisse bei einer erfindungsgemässen Vorrichtung gemäss Figur 4

Für ein besseres Verständnis der Erfindung wird im Folgenden zunächst grob auf die Verhältnisse bei ARC-Quellen gemäss dem Stand der Technik eingegangen. Figur 2 zeigt eine Arc Verdampfer Anordnung 201 mit einer Anode 203 im Abstand von der Quellenkathode 209 gemäss dem Stand der Technik. Die Quellenkathode wird durch eine Kühlvorrichtung 211 gekühlt und ist mit dem negativen Pol 213 einer DC-Stromversorgung verbunden. Hinter der Quellenkathode sind magnetische Mittel 215 vorgesehen welche für den Aufbau eines Magnetfeldes oberhalb der Targetoberfläche sorgen. Ein Brennfleck 205 entlässt einen hohen Strom und damit eine Vielzahl von Elektronen in den Verdampferraum. Als leitfähiges Medium steht das ARC-Plasma zur Verfügung. Nachdem sich gemäss dem Stand der Technik die Anode 203 nicht in unmittelbarer Nähe des Brennflecks 205 befindet, müssen die geladenen Teilchen auf dem Weg zur weiter entfernten Anode das Magnetfeld kreuzen. Relevant ist die Bewegung eines geladenen Teilchens mit Ladung q, Masse m, Geschwindigkeit v am Ort r in einem elektrischen Feld **E(r)** und magnetischen Feld **B(r).** Dabei wirken verschiedene Kraftkomponenten: Für die Bewegung parallel zum **B**-Feld wirkt eine Kraft proportional zu qE. Für die Bewegung senkrecht zum Magnetfeld wirkt die Kraft proportional zu q(E⊥+v⊥xB), was zur Gyrationsbewegung führt, die aber durch eine ***ExB-*** Drift überlagert ist. Dies führt zu einem "virtuellen" Strompfad 207 wie er in Figur 2 angedeutet ist. Beim Durchlaufen dieser an eine Spirale erinnernde Bahn auf dem Weg zur entfernten Anode 203 wird das im Beschichtungsraum befindliche Arbeitsgas (z.B. Ar, N₂) stark ionisiert. Es kommt zur Bildung von Gas-Ionen, zu einer Spannungserhöhung der Entladung und einem Potentialsprung vor der Kathode. Ausserdem wird eine Reduktion der Beschichtungsrate beobachtet.

In Figur 3. ist eine Ausführung der erfindungsgemässen ARC-Verdampferquelle 301 gezeigt. Dies ist nur eine beispielhafte Variante und kann durch verschiedenste Ausführungen realisiert werden. Die Kathode 309 besteht aus dem zu verdampfenden Material und ist über den Stromanschluss an den negativen Pol einer Stromquelle angeschlossen. Über die magnetischen Mittel 305 wird ein Magnetfeld an der Kathodenoberfläche erzeugt, welches eine schnelle Funkenbewegung erlaubt.

Die Magnetfeldlinien welche von der Targetoberfläche ausgehen sind innerhalb eines grossen Flächenanteils so gestaltet, dass sie vorwiegend Komponenten parallel zur Oberfläche der Kathode 309 haben und eine kurze Verbindung zur Anode 303, die sich ringförmig um den Kathodenrand erstreckt, ermöglichen. Die in Fig. 3 dargestellte ARC-Verdampferquelle kann aber sowohl als axialsymmetrische Rundkathode als auch als Rechteckkathode realisiert sein. Kathodenbereiche im Zentrum bzw. entlang der Mittellinie weisen immer senkrecht zur Targetoberfläche verlaufende Feldlinien auf und sollten daher von der Erosion ausgenommen werden. Dies kann beispielsweise mit einer Blende oder mittels einer gefüllten Aussparung geschehen (beides nicht gezeigt). Die magnetische Feldstärke im Bereich 6 beträgt 40 Gauss bis 500 Gauss. Vorteilhaft sind 60 bis 100 Gauss und besonders vorteilhaft sind 200 bis 500 Gauss für besonders glatte Schichtergebnisse. Die erfindungsgemässe Anordnung der Anode in Kombination mit der magnetischen Feldverteilung erlaubt den Betrieb bei solch hohen Magnetfeldern. Als Targetmaterial der Kathode 309 können die für die Hartstoffbeschichtung üblichen Materialien wir Ti, TiAl, Al, AlCr, TiSi, Cr usw. verwendet werden.

In ARC-Verdampferanordnung 301 gemäss Fig. 3 ist die Anode 303 in Kombination mit dem von den magnetischen Mitteln 305 erzeugten magnetischen Feld erfindungsgemäss so in der Nähe der Kathode 309 angeordnet, dass die magnetischen Feldlinien den Strompfad 307 auf direktem Weg vom Brennfleck 315 zur Anode 303 erlauben. Eine wie oben beschriebene Drift lässt sich im Wesentlichen vermeiden, wenn das elektrische Feld im Wesentlichen parallel zum magnetischen Feld verläuft. In einer vorteilhaften Ausführungsform der vorliegenden Erfindung wird die Anode so ausgestaltet, dass dies bei angelegter Spannung und angeschaltetem Magnetfeld erfüllt ist und bis auf die zentralen Magnetfeldlinien nahezu alle oder zumindest ein Grossteil der Magnetfeldlinien zur Anode führen. Die Bahn der Elektronen wird durch den Larmor Radius charakterisiert und beschreibt eine Gyration um den Feldlinienverlauf. Der Gyrations Radius für ein Elektron beträgt für 10 Gauss ca. 1mm für 100 Gauss ca. 0.1mm. Die Bahn ist daher bei entsprechenden magnetischen Feldstärken gut entlang der Feldlinie lokalisiert. Die Wirkung einer solchen Anordnung ist eine Reduktion der Gesamt Entladungsspannung und eine Erhöhung der Beschichtungsrate. Das Arbeitsgas in der Nähe des Targets wird nur geringfügig ionisiert.

Eine mögliche vorteilhafte Anwendung der vorliegenden Erfindung ist das Metall Ionen Ätzen (MIE).

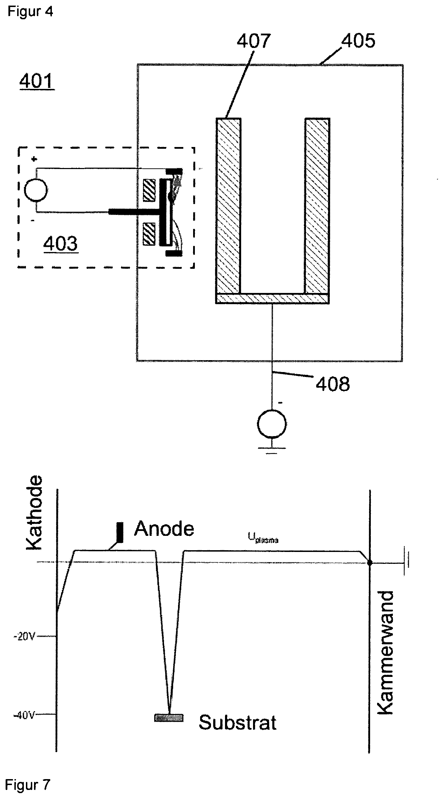

Dies wird durch eine weitere Besonderheit der erfinderischen Arc-Verdampfungsquelle möglich. Die Besonderheit besteht in der Möglichkeit eines stabilen Betriebs selbst ohne Arbeitsgas im Vakuum mit Drücken kleiner als 1E-03Pa. Dabei wird es durch die gute elektrische Anbindung des Arc -Spots 5 an die Anode möglich, dass die elektrische Leitfähigkeit des Metallplasmas 8 ausreicht um den Strom von der Kathode zur Anode zu tragen 9. Der Metalldampf aus der Arc Quelle ist zu einem hohen Grad einfach und mehrfach ionisiert und kann durch die Biasspannung 12 auf das Substrat 11 beschleunigt werden. Damit kann ein Metall Ionen Ätzen (MIE) effektiv realisiert werden Eine entsprechende MIE-Vorrichtung 401 ist in Figur 4 gezeigt: Diese umfasst eine ARC-Verdampfungsquelle 403 und eine Substrathalterung 407, welche in einer Vakuumkammer 405 angeordnet sind. Die Substrathalterung, bestückt mit zu ätzenden Substraten (nicht gezeigt) wird mit Hilfe einer Spannungsquelle 408 auf negatives Potential gelegt, wodurch die an der ARC-Verdampfungsquelle entstehenden positiven Ionen zu den Substraten hin beschleunigt werden.

Bemerkenswert ist, dass der Betrieb im Vakuum bei sehr geringen Stromstärken aufrechterhalten werden kann: Bei der Auswahl des Parameterraumes für den oben genannten MIE Prozess ergab sich erstaunlicherweise, dass selbst bei sehr geringem Entladestrom der ARC -Entladung ein stabiler Prozess möglich ist. Aufgrund der Magnetfeldlinien wird das Potential der Anode bis kurz vor die Targetoberfläche "verschleppt", wodurch der Strompfad aufrechterhalten werden kann.

Für Aluminium konnte ein stabiler Prozess bei Stromstärken bis hinunter zu knapp oberhalb 10 A und für Titan bei Stromstärken bis hinunter zu knapp oberhalb 40 A festgestellt werden. Mit der erfindungsgemässen ARC-Verdampfungsquelle kann Metall Ionen Ätzen auch mit anderen Materialien, wie zum Beispiel Cr, Nb, Ta und andere Metalle mit hohem Ionisierungsgrad und hohem Anteil an Mehrfachionisation stabil durchgeführt werden.

Die erfindungsgemässe ARC-Verdampfungsquelle lässt sich mit unterschiedlichen Beschaltungen realisieren, die ihrerseits wiederum selbst erfinderisch sind.

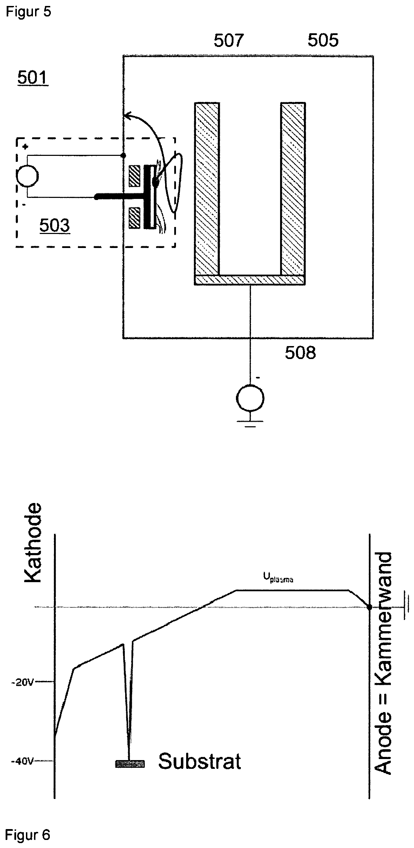

Zunächst wird wieder zum besseren Verständnis die Situation beim Verwenden einer ARC-Verdampfungsquelle gemäss dem Stand der Technik skizziert. Dementsprechend ist in Figur 5 eine nach dem Stand der Technik angegebene Beschaltung dargestellt.

Dabei bildet die Kammerwand des Rezipienten 505 die Anode. Die magnetischen Feldlinien, welche vom Target ausgehen, haben keine direkte Verbindung mit der Anode. In der Figur 5 gezeigt ist eine Beschichtungsvorrichtung 501 mit einer ARC-Verdampfungsquelle 503 die in einem Rezipienten 505 angeordnet ist, wobei in dem Rezipienten 505 ausserdem ein Substrathalter 507 angeordnet ist der mittels einer Spannungsquelle 508 auf negative Spannung gelegt werden kann. Speziell bei hohen magnetischen Feldstärken, welche sich auf die Schichtrauhigkeit positiv auswirken, kommt es zu starker Ionisation des Arbeitsgases (z.B. N2) und damit zu einer Erhöhung der Entladespannung bzw. einem Potentialfall vor dem Target. Ausserdem kommt es durch die hohe Elektronentemperatur der Entladungen (2eV-5eV) zu einer Verzerrung des Potentials vor dem Substrat, wie in Figur 6 skizziert.

In Figur 4 wurde demgegenüber eine erfindungsgemässe Ausführungsform skizziert und bereits weitgehend erläutert.

Das mit hohem Ionisationsgrad verdampfte Kathodenmaterial wird über eine Biasspannung 408 auf das Substrat beschleunigt. Das elektrische System Kathode 1 - Anode 4 ist floatend zur Kammermasse 10 ausgeführt.

Das Plasmapotential Uₚₗₐₛₘₐ ist in dieser Ausführungsform an die Kammerwand gebunden.

Der Entladungsstrom der Arc- Quelle fliesst von der Kathode zur Anode. Die Kathodenspannung in diesem Beispiel von ca. -16 bis -25V wird gegen die Anode 4 aufgebaut. Der Substratbias aus Generator 408 beschleunigt Ionen aus dem Plasma mit Plasmapotential Uₚₗₐₛₘₐ gegen das Substrat. Der Potentialverlauf vor dem Substrat ist, wie in der Figur 7 dargestellt, nicht mehr verzerrt, da die Elektronentemperatur eines solchen Plasmas lediglich ca. 0.3eV bis 1eV beträgt.

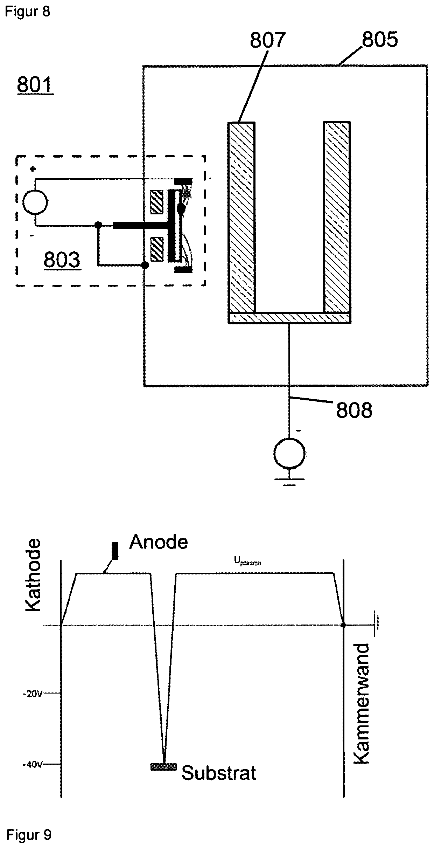

Eine weitere Ausführungsform ist in Figur 8 gezeigt, nämlich eine Beschichtungsvorrichtung 801 mit einer ARC-Verdampfungsquelle 803 die in einem Rezipienten 805 angeordnet ist, wobei in dem Rezipienten 805 ausserdem ein Substrathalter 807 angeordnet ist der mittels einer Spannungsquelle 808 auf negative Spannung gelegt werden kann. Gemäss dieser Ausführungsform wird im Unterschied zur Figur 4 die Kathode des in Figur 4 floatenden Kathoden-Anoden Systems auf Kammermasse (Ground) geschalten. Dabei werden die Potentiale verschoben, wie in Figur 9 dargestellt. Das Kathodenpotential wird zur Kammermasse verschoben. Der ARC- Entladestrom verläuft von Kathode zu Anode. Die von der Spannungsquelle (Biasversorgung) 808 aufgebrachte Spannung (in diesem Beispiel 40V erzeugt eine Beschleunigung der Ionen mit einem zusätzlichen Anteil Ubias + Uplasma

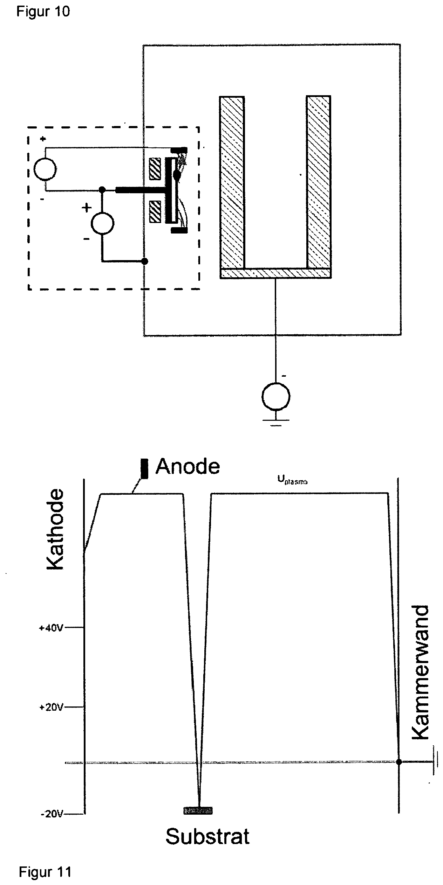

In Figur 8 ist die Kathode mit der Kammer kurzgeschlossen und liegt somit auf Kammermasse. Es ist aber auch möglich Kathode und Kammer über eine Spannungsquelle zu verbinden und hierdurch eine zusätzliche Potentialverschiebung zu erreichen. Damit kann erreicht werden, dass das Plasmapotential, zumindest vor der Anode, stark positiv wird. Dies ist in den Figuren 10 und 11 gezeigt.

## Patentansprüche

1. ARC-Verdampfungsvorrichtung umfassend
- eine Kathode (309) die eine Oberfläche mit demjenigen Material enthält, welches verdampft werden soll
- magnetische Mittel (305) welche zu einem Magnetfeld über der Oberfläche der Kathode (309) führen
- eine Anode (303) zur Absorption der Elektronen, die während des Verdampfungsprozesses aus der Kathode (309) herausgezogenen werden
- eine Spannungsquelle, die es erlaubt zumindest zeitweise die Anode (303) gegenüber der Kathode (309) auf positives Potential zu legen
***dadurch gekennzeichnet, dass*** die Anode (303) in der unmittelbaren Nachbarschaft der Kathode (309) und in Kombination mit dem von den magnetischen Mitteln (305) erzeugten Magnetfeld angeordnet ist dergestalt, dass Magnetfeldlinien auf kurzer Verbindung von der Oberfläche der Kathode (309) zur Anode (303) geführt werden, wobei die aus der Oberfläche der Kathode (309) austretenden Magnetfeldlinien auf die Anode (303) treffen falls sie nicht in einem zentralen Bereich der Kathode (309) aus der Oberfläche der Kathode (309) treten und wobei im zentralen Bereich der Kathode (309) Vorkehrungen getroffen wurden, welche dessen Erosion während des Betriebes der Verdampfungsvorrichtung im Wesentlichen verhindern.

2. ARC-Verdampfungsvorrichtung nach Anspruch 1, ***dadurch gekennzeichnet, dass*** die Position und Geometrie der Anode (303) im Verhältnis zur Kathode (309) so gewählt ist, dass die Magnetfeldlinien unter einem Winkel von über 45° und vorzugsweise im Wesentlichen senkrecht auf die Oberfläche der Anode (303) treffen.

3. ARC-Verdampfungsvorrichtung nach Anspruch 2, ***dadurch gekennzeichnet, dass*** die Position und Geometrie der Anode (303) im Verhältnis zur Kathode (309) so gewählt ist, dass die Magnetfeldlinien und die elektrischen Feldlinien welche auf die Anode (303) treffen im Wesentlichen parallel zueinander verlaufen.

4. ARC-Verdampfungsvorrichtung nach einem der vorangehenden Ansprüche 1 bis *3, **dadurch gekennzeichnet, dass*** die Vorkehrungen eine Blende im zentralen Bereich der Oberfläche der Kathode (309) umfassen.

5. Vakuumbehandlungsvorrichtung (401, 801) mit einem Rezipienten (405, 805) und einer Halterung (407, 807) für Substrate und mit einer ARC-Verdampfungsvorrichtung (403, 803) nach einem der vorangehenden Ansprüche.

6. Vakuumbehandlungsvorrichtung nach Anspruch 5, ***dadurch gekennzeichnet, dass*** die Kathode der ARC-Verdampfungsvorrichtung gegenüber dem Rezipienten auf einem Potential gehalten wird welches floatend, gleich oder positiv ist.

## Claims

1. Arc evaporation device, comprising:
- a cathode (309) comprising a surface with the material that is to be evaporated,
- magnetic means (305) that lead to a magnetic field over the surface of the cathode (309),
- an anode (303) for absorbing the electrons that are extracted out of the cathode (309) during the evaporation process,
- a voltage source which allows putting the anode (303) at least partly at positive potential relative to the cathode (309),
**characterized in that** the anode (303) in the direct vicinity of the cathode (309) and in combination with the magnetic field generated by the magnetic means (305) is designed in such a way that the magnetic field lines are directed in a short connection from the surface of the cathode (309) to the anode (303), wherein the magnetic field lines exiting from the surface of the cathode (309) hit the anode (303), if they do not exit from the surface of the cathode (309) at a central area of the cathode (309) and wherein in the central area of the cathode (309) measures have been taken that essentially prevent its erosion during operation of the evaporation device.

2. Arc evaporation device according to claim 1, **characterized in that** the position and geometry of the anode (303) in relation to the cathode (309) are chosen in such a manner that the magnetic field lines hit the surface of the anode (303) at an angle of over 45° and preferably essentially perpendicularly.

3. Arc evaporation device according to claim 2, **characterized in that** the position and geometry of the anode (303) in relation to the cathode (309) are chosen in such a manner that the magnetic field lines and the electric field lines that hit the anode (303) run essentially parallel to one another.

4. Arc evaporation device according to one of the preceding claims 1 to 3, **characterized in that** the measures comprise a shutter in the central area of the surface of the cathode (309).

5. Vacuum treatment device (401, 801) with a recipient (405, 805) and a substrate holder (407, 807) and with an arc evaporation device (403, 803) according to one of the preceding claims.

6. Vacuum treatment device according to claim 5, **characterized in that** the cathode of the arc evaporation device is kept in relation to the recipient on a potential that is floating, at the same polarity or positive.

## Revendications

1. Dispositif d'évaporation par arc comprenant
- une cathode (309) contenant une surface avec ce materiél qui doit être vaporisé
- des moyens magnétiques (305) conduisant à un champ magnétique au-dessus de la surface de la cathode (309)
- une anode (303) pour absorber les électrons qui sont extraits pendant le processus d'évaporation de la cathode (309)
- une source de tension qui permet de mettre du moins temporairement l'anode (303) à un potentiel positif par rapport à la cathode (309)
**caractérisé par le fait que** l'anode (303) est disposée à proximité immédiate de la cathode (309) et en combinaison avec le champ magnétique généré par les moyens magnétiques (305) de telle manière que des lignes de champ magnétique soient conduites en connexion courte de la surface de la cathode (309) à l'anode (303), les lignes de champ magnétique sortant de la surface de la cathode (309) frappant l'anode (303), si elles ne sortent pas dans une région centrale de la cathode (309) de la surface de la cathode (309) et dans la région centrale de la cathode (309) des mesures ayant été prises qui évitent son érosion pendant l'opération du dispositif d'évaporation.

2. Dispositif d'évaporation par arc selon la revendication 1, **caractérisé par le fait que** la position et la géometrie de l'anode (303) par rapport à la cathode (309) sont choisies de manière que les lignes de champ magnétique frappent la surface de l'anode (303) sous un angle de plus de 45° et de préférence essentiellement perpendiculairement.

3. Dispositif d'évaporation par arc selon la revendication 2, **caractérisé par le fait que** la position et la géometrie de l'anode (303) par rapport à la cathode (309) sont choisies de manière que les lignes de champ magnétique et les lignes de champ électrique frappant l'anode (303) soient essentiellement parallèles les unes aux autres.

4. Dispositif d'évaporation par arc selon une des revendications précédentes 1 à 3, **caractérisé par le fait que** les mesures comprennent un bandeau dans la région centrale de la surface de la cathode (309).

5. Dispositif de traitement sous vide (401, 801) avec un récipient (405, 805) et un support (407, 807) pour des substrats et avec un dispositif d'évaporation par arc (403, 803) selon une des revendications précédentes.

6. Dispositif de traitement sous vide selon la revendication 5, **caractérisé par le fait que** la cathode du dispositif d'évaporation par arc est tenue par rapport au récipient à un potential qui est flottant, égal ou positif.
